# EUROPEAN PATENT APPLICATION

(11) **EP 2 515 137 A1**
(43) Date of publication of application: **24.10.2012**
(21) Application number: 11162955.6
(22) Date of filing: 19.04.2011
(51) Int. Cl.: G01R 33/563, G06T 15/00, G06T 15/50

(54) **Processing a dataset representing a plurality of pathways in a three-dimensional space**

(71) Applicant: UMC Utrecht Holding B.V., 3584 CM Utrecht (NL)
(72) Inventor: Leemans, Alexander Lucas Guy, 3584 CX, Utrecht (NL)
(74) Representative: van Westenbrugge, Andries

(57) **Abstract**

A system for processing a dataset representing a plurality of pathways in a three-dimensional space comprises an orientation associating unit for associating an orientation with at least part of at least one pathway of the plurality of pathways, to obtain an associated orientation. The system comprises an opacity associating unit for associating an opacity level with at least part of the at least one pathway based on the associated orientation, to obtain an associated opacity level. The opacity associating unit comprises an orientation comparator for comparing the associated orientation with a reference orientation. The orientation comparator is arranged for computing a degree of similarity between the associated orientation and the reference orientation.

## Description

### FIELD OF THE INVENTION

The invention relates to processing a dataset representing a plurality of pathways in a three-dimensional space.

### BACKGROUND OF THE INVENTION

A lot of techniques exist to create a visualization of three-dimensional data. Examples include isosurface rendering and volume rendering. A special case of three-dimensional (3D) data is formed by datasets representing pathways in a 3D space. Depending on the complexity and the number of the pathways in a dataset, it may be challenging for a user to obtain a clear view of the structure of the dataset. An example of pathways that may be represented and visualized includes nerve cells. Other examples will be described elsewhere in this description. Pathways may be visualized as lines, wires or tubes. However, when a plurality of crossing pathways is represented in the dataset, it may be the case that the pathways are obscured by each other or intersect each other. This makes it difficult to inspect the structure of the dataset in a reliable way.

Diffusion magnetic resonance imaging (MRI) uses the physical property that water molecules inside organic tissues often diffuse anisotropically. If there are aligned structures in the tissue, the apparent diffusion coefficient (ADC) of water may vary depending on the orientation along which the diffusion-weighted (DW) measurements are taken. Diffusion-weighted imaging (DWI) combines DW measurements with MRI. This enables mapping of both diffusion constants and diffusion anisotropy inside the brain and revealing valuable information about axonal structures.

"MR diffusion tensor spectroscopy and imaging", by Basser PJ, Mattiello J, LeBihan D, in Biophys J. 1994 Jan; 66(1):259-67 discloses the concept of diffusion tensor MRI (DTI).

"Diffusion MRI: Theory, Methods, and Applications", by Derek K. Jones (ed.), First Edition, Oxford University Press, 2010, hereinafter: Jones et al., reviews the research field of diffusion MRI. Chapter 21 of Jones et al. describes a number of visualization approaches in diffusion MRI.

DTI can quantify the degree of anisotropy and the structural orientation information quantitatively and has boosted the research in diffusion MRI. The DTI approach provides a way to model this complex neuroanatomical information using six parameters. Jones et al. further describes more sophisticated non-tensor models that describe diffusion properties and extract finer anatomical information from each voxel. 3D reconstruction technologies for white matter tracts are also being developed. These acquisition protocols and non-tensorial models generate increasingly complex networks of pathways that contain valuable information about the structure of the brain. This increasing complexity of the networks of pathways makes it more difficult to inspect the anatomical structures using conventional tractography visualization approaches. Many pathways overlap each other making the visualization cluttered and obscure. As a result, it becomes very tedious to distinguish between differently organized subsets of pathways.

In diffusion MRI, visualization methods are used for inspecting data quality, investigating specific diffusion properties, interpreting results from quantitative analyses, and testing new reconstruction techniques. Existing display methods for displaying diffusion MRI data include two-dimensional (2D) image maps of specific diffusion properties and 3D display methods, such as glyph representations, volume and surface renderings, (hyper-) streamlines, and streamsurfaces. To allow for inspection of the inner parts of the brain, section views or thick slab visualizations are typically generated.

### SUMMARY OF THE INVENTION

It is an object of the invention to provide an improved processing of a plurality of pathways defined in a three-dimensional space. A first aspect of the invention provides a system for processing a dataset representing a plurality of pathways in a three-dimensional space, comprising
an orientation associating unit for associating an orientation with at least part of at least one pathway of the plurality of pathways, to obtain an associated orientation; and
an opacity associating unit for associating an opacity level with at least part of the at least one pathway based on the associated orientation, to obtain an associated opacity level.

The opacity level based on the orientation, or direction, of at least part of at least one pathway allows to selectively make pathways more or less transparent, depending on the orientation of that pathway in 3D space. It has been found, that this makes it possible to inspect particular structures that are of interest, while hiding other structures that might obstruct the view. This may reduce the need for cut planes. Consequently, the positioning of a cut plane is also not necessary. Moreover, because the opacity level is based on a structural property of the pathways, the boundary between hidden (transparent) structures and shown (at least somewhat opaque) structures does not have to be planar. Accordingly, opacity may be controlled on a much more detailed level compared to a cut plane.

The opacity associating unit may comprise an orientation comparator for comparing the associated orientation with a reference orientation. This allows to selectively set different opacity levels for different orientations of the pathway. Consequently, pathways in orientations that one is not interested in for a particular task may be made more transparent, so they do not obstruct the structures of interest.

The orientation comparator may be arranged for computing a degree of similarity between the associated orientation and the reference orientation. This is a suitable way to compare the orientations. Such a degree of similarity may be, for example, an inner product of the vectors representing the associated orientation and the reference orientation. An absolute value of such an inner product may also be used. Another example of a suitable degree of similarity is an angle between these orientation vectors.

The opacity associating unit may be arranged for using a monotonically increasing or monotonically decreasing mapping to map the degree of similarity to the opacity level. This makes the assignment of opacity levels consistent and easy to comprehend. This way, varying levels of opacity may be assigned to pathways having associated orientations with different degrees of similarity compared to the reference orientation.

The opacity associating unit may be arranged for associating an opacity level corresponding to a substantial transparency with at least part of a pathway having an orientation substantially parallel or substantially orthogonal to the reference orientation. This defines two useful modes of display, one hiding the pathways with orientations substantially orthogonal to the reference orientation. Another mode hides the pathways substantially parallel to the reference orientation.

The system may comprise a user interface element for enabling a user to select the reference orientation. This allows the user to inspect structures having a particular orientation, by making structures with other orientations transparent.

The system may comprise a graphical subsystem for displaying the at least part of the pathway of the plurality of pathways as seen from a viewing orientation on a display, using the associated opacity level. The opacity level may be applied during a visualization operation of the dataset. This facilitates the inspection.

The orientation comparator may be arranged for using the viewing orientation as the reference orientation. This way, the pathways parallel to the viewing orientation may be made transparent (or opaque). This is particularly useful, because the opacity of the pathways may be automatically adjusted when the viewing orientation is changed. Moreover, in some applications, such as diffusion MRI, the pathways parallel to the viewing orientation may be particularly obstructive for some of the deeper structures in the brain. Consequently, making these structures transparent may provide an improved view of these deeper structures.

The system may comprise a reference orientation unit for setting a reference orientation having a predetermined orientation with respect to an object represented by the dataset. This makes it possible to assign the transparency values in a reproducible and/or efficient way. Reproducible viewing protocols may be implemented in this way. For example, the object and orientation may be known from metadata accompanying the dataset, or this orientation may be determined using image processing techniques.

The system may comprise a reference orientation unit for setting a reference orientation used for a particular part of a pathway in dependence on a position of the part of the pathway in the three-dimensional space. This makes the assignment of opacity levels more flexible. It may provide improved control of structures that are visualized and structures that are hidden.

The reference orientation may be defined in terms of a curvilinear coordinate system. This provides a detailed control of the orientations to hide or show. Such a curvilinear coordinate system may be used to model structures having an a priori known appearance, so that specific parts of such a structure may be selectively shown or hidden. For example, a star shape may be hidden while showing a spherical or circular shape. Examples of curvilinear coordinate systems include spherical coordinates and cylindrical coordinates.

The system may comprise a pathway generator for generating the dataset comprising the plurality of pathways based on a medical image dataset. This is a suitable way to obtain the dataset. The medical image dataset may be obtained using a medical imaging apparatus, such as an MRI scanner. The object and/or orientation thereof may also be determined by analyzing the medical image dataset.

The dataset may comprise a diffusion magnetic resonance tractography dataset. This kind of dataset typically contains a complex network of pathways that may be inspected using the techniques described herein.

The system may be part of a workstation allowing a user to interact with the system, to inspect a dataset.

Another aspect of the invention provides a method of processing a dataset representing a plurality of pathways in a three-dimensional space, comprising
associating an orientation with at least part of at least one pathway of the plurality of pathways, to obtain an associated orientation; and
associating an opacity level with at least part of the at least one pathway based on the associated orientation, to obtain an associated opacity level.

A computer program product may comprise instructions for causing a processor system to perform the method described herein.

The person skilled in the art will understand that the features described above may be combined in any way deemed useful. Moreover, modifications and variations described in respect of the system may likewise be applied to the method and to the computer program product, and modifications and variations described in respect of the method may likewise be applied to the system and to the computer program product.

### BRIEF DESCRIPTION OF THE DRAWINGS

In the following, aspects of the invention will be elucidated by means of examples, with reference to the drawings. The drawings are diagrammatic and not drawn to scale.
Fig. 1 is a block diagram of a system for processing a dataset representing a plurality of pathways.
Fig. 2 is a flowchart of a method of processing a dataset representing a plurality of pathways.
Fig. 3 is an example of a dorsoventral view of a diffusion MRI tractography image dataset.
Fig. 4 is an example of an application of a transparency mapping, wherein the reference orientation is coupled to the viewing direction.
Fig. 5 is an example of an application of a transparency mapping, wherein the reference orientation is anteroposterior.
Fig. 6 is an example of an application of a transparency mapping, wherein the reference orientation is lateral.
Fig. 7 is an example of a lateral view of a diffusion MRI tractography image dataset.
Fig. 8 is an example of an application of a transparency mapping, wherein the reference orientation is coupled to the viewing direction.
Fig. 9 is an example of an application of a transparency mapping, wherein the reference orientation is dorsoventral.
Fig. 10 is an example of an application of a transparency mapping, wherein the reference orientation is anteroposterior.
Fig. 11 shows a detail of a plurality of intersecting pathways.

### DETAILED DESCRIPTION OF EMBODIMENTS

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope and spirit of the invention. In addition, descriptions of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and are not intended to limit the scope of the invention.

It is to be understood that the singular forms "a," "an," and "the" include plural referents unless the context clearly dictates otherwise. Thus, for example, reference to "a component surface" includes reference to one or more of such surfaces.

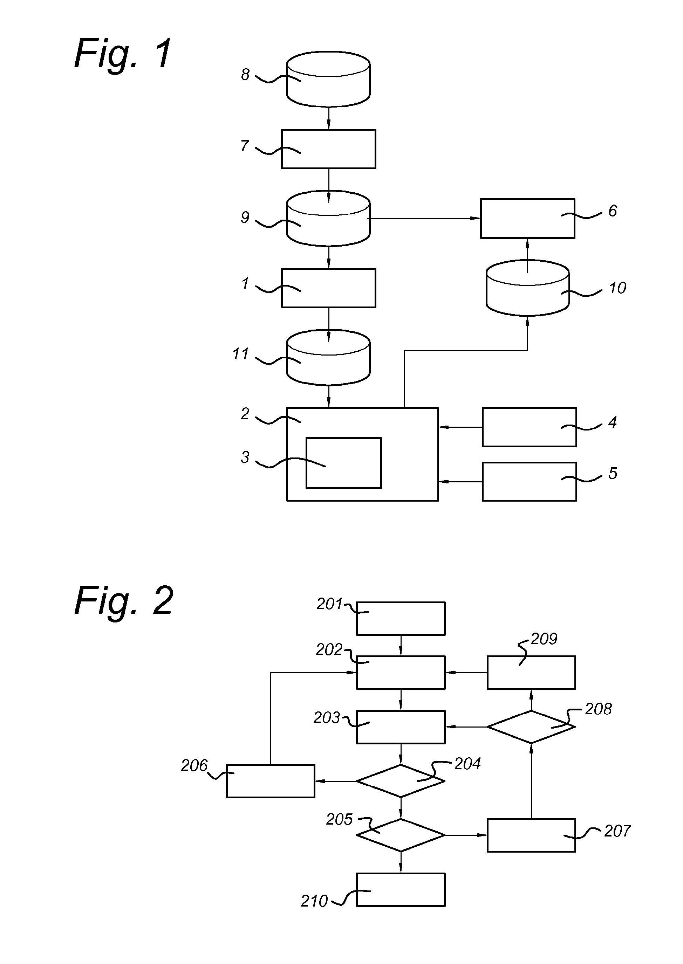

Fig. 1 illustrates a system for processing a dataset 9. The dataset 9 represents a plurality of pathways in a three-dimensional space.

Examples of pathways that may be represented and visualized include vessels, bronchi, nerve cells, tubes, lines, and wires used (or planned to be used) in construction, plumbing, electricity distribution, electronic devices, and communication networks. Pathways in a dataset may also have the function to model geometric aspects of molecules. Pathways may also be paths followed by a signal or an object. Consequently, another example of a pathway is an orbit. A pathway may be a trajectory or a spatial curve.

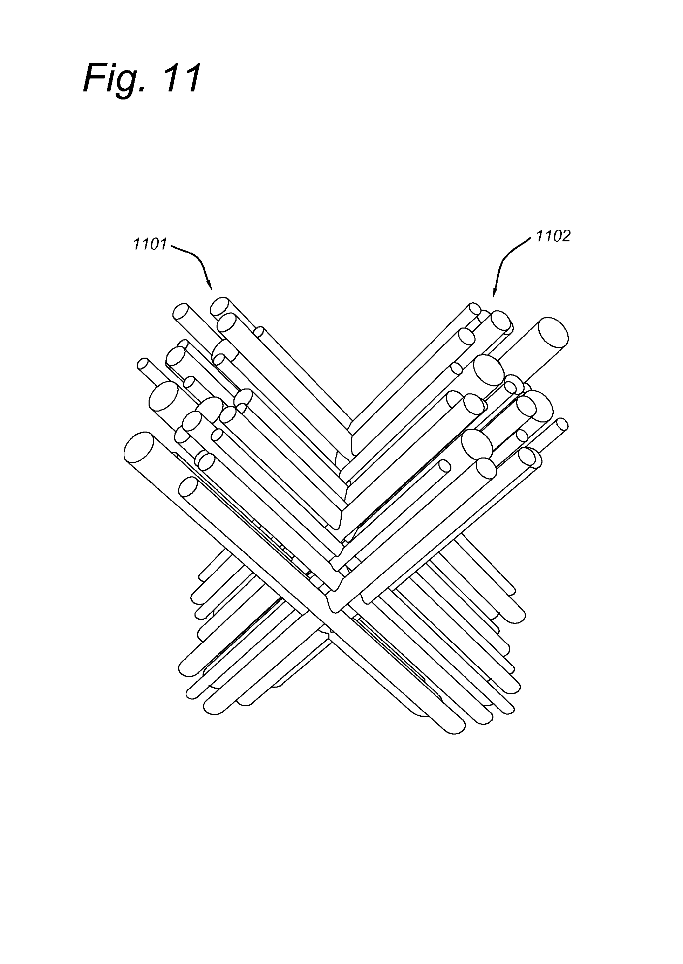

In Fig. 11 it is shown how a first bundle of pathways 1101 crosses a second bundle of pathways 1102. The first bundle of pathways 1101 has a different orientation than the second bundle of pathways 1102. This figure illustrates the complexity of the structures that may appear in a plurality of pathways in a three-dimensional space.

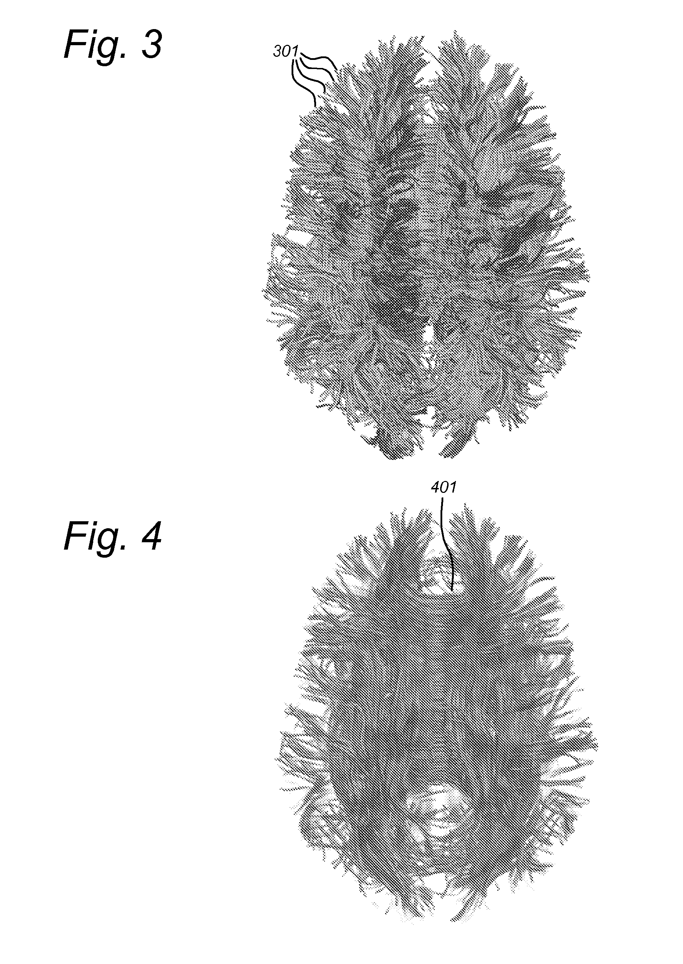

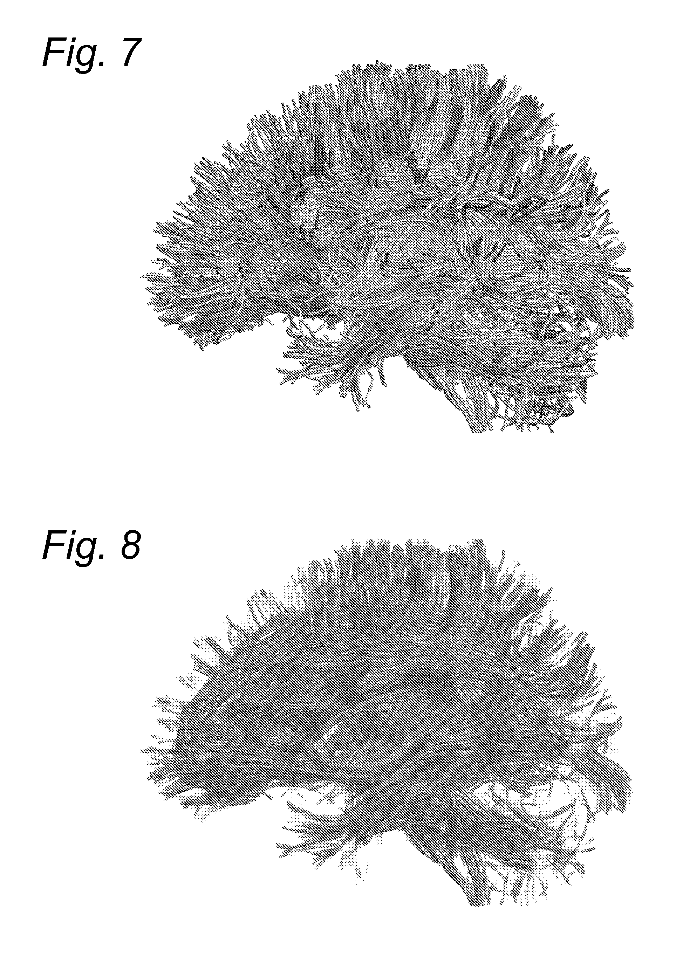

Fig. 3 shows a dorsoventral view of a plurality ofpathways 301 obtained from diffusion MRI tractography imaging. The pathways 301 are displayed as wires. However, this is not a limitation. Fig. 7 shows a lateral view of the same dataset. Clearly, many crossing pathways 301 are present in this dataset and the pathways overlap each other in the two views shown in Figs. 3 and 7.

Returning to Fig. 1, the system may comprise a pathway generator 7 arranged for receiving a raw dataset 8 comprising measurement data. The pathway generator 7 is arranged for analyzing the raw dataset 8, for example using image processing or signal processing techniques, to extract a plurality of pathways from the raw dataset 8. This plurality of extracted pathways are stored in the dataset 9. Alternatively, the system may receive the dataset 9 comprising a plurality of pathways in a three-dimensional space from an external source.

The raw dataset 8 may comprise a diffusion MRI dataset, and the pathway generator 7 may be arranged for extracting the plurality of pathways from the diffusion MRI dataset using a diffusion tensor model or a non-tensor model. This extraction process is known as diffusion magnetic resonance tractography. Such models and processes are known from, for example, Jones et al.. However, this is not a limitation. For example, blood vessels may be extracted from a CT or MRI dataset using techniques known in the art. In such a case, the different pathways may include different segments of a vascular tree. Other kinds of datasets representing a plurality of pathways in a three-dimensional space can also be used in conjunction with the techniques described herein.

The system may comprise an orientation associating unit 1 arranged for associating an orientation with at least part of at least one pathway of the plurality of pathways. It should be noted that a pathway can have more than one orientation associated with it. In particular, when the pathway is not strictly linear, the orientation is different for different segments or points of the pathway. Herein, the orientation may be regarded to be a local longitudinal axis of the pathway. For example, the orientation may be computed as a direction vector or tangential vector of the pathway. However, the orientation may also be computed for a segment of a pathway, for example by computing an average orientation of the pathway along the segment. It is also possible to use a moving average of the tangential vector of the pathway as the orientation of the pathway. More possibilities to determine an orientation of at least part of a pathway will be apparent to the person skilled in the art in view of this description.

For example, the orientation may be represented as a vector (rᵢ, *sᵢ, tᵢ*), wherein i is an index that denotes the part of the pathway with which the orientation (rᵢ, *sᵢ, tᵢ)* is associated. For example, the vector is a tangential vector of the pathway. However, this is not a limitation. For example, it is also possible to generate a vector representing the average orientation of a segment of a pathway.

The orientation associating unit 1 may be arranged for processing some or all of the pathways or parts thereof. This way, the orientation information may be made available for the whole dataset of pathways 9. It is also possible to compute the orientation information for pathways in a region of interest. It will be understood that more than one orientation can be associated with each pathway. Since pathways may be curved, different segments of a pathway may have different orientations associated therewith. It is also possible to approximate the orientation for a single point of the pathway. This may be performed for a large number of points along the pathway, thus generating detailed information about the orientations of the pathways. It is also possible that the orientation associating unit 1 may be invoked by the opacity associating unit 2 to compute the orientation for one or more particular points specified by the opacity associating unit 2.

An orientation dataset 11 may be generated by the orientation associating unit 1. The orientation dataset 11 may comprise a list of associations. Each association in the list may comprise an identifier of at least part of at least one pathway and a representation of the associated orientation. Alternatively, the orientation may be stored in a data field of a data structure representing the pathway. Other ways to represent and/or store the orientations will be apparent to the person skilled in the art in view of this description.

The system may further comprise an opacity associating unit 2 arranged for associating an opacity level with at least part of at least one pathway. The opacity level is based on the associated orientation. This way, an associated opacity level is obtained. This opacity level may be used to adjust the display of the dataset 9. It will be understood that the opacity level may also be defined in terms of a transparency level, because opacity and transparency may be regarded reciprocative terms.

The opacity associating unit may be arranged for comparing orientations of different pathways, to give a higher opacity to pathways having nearby pathways with a similar orientation. This way, bundles may be given priority over intersecting tangles of pathways. The orientation of nearby pathways, the number of nearby pathways having a particular orientation, and the distance to the nearby pathways may contribute to the opacity value assigned by the associating unit. This information may further be combined with voxel information from the raw dataset 8. Alternatively, straight pathways may be given a higher opacity than curved pathways. This may be achieved, for example, by comparing orientations of different segments of the same pathway.

The opacity associating unit 2 may comprise an orientation comparator 3 arranged for comparing the associated orientation of a pathway with a reference orientation. This reference orientation may be determined beforehand. Examples of how to determine a reference orientation will be elucidated hereinafter. The comparison may result in a binary result (similar/not similar). The similarity may be based on exact comparison. In such a case, the associated orientation should be identical to the reference orientation in order to be classified "similar". The similarity may also be based on a threshold comparison. For example, if the angle between the two vectors representing the orientations is below the threshold, then the comparison may generate the outcome "similar". The opacity associating unit may be arranged for determining an opacity value based on the result of the comparison. For example, segments of pathways oriented parallel to the reference orientation may be associated with full transparency, and other segments may be associated with full opacity, or vice versa.

For example, the reference orientation may be represented by a vector (*u, w, v*). The comparison could comprise computing an inner product ((*rᵢ, sᵢ, tᵢ), (u,* w, *v*)). Herein, the associated orientation (*rᵢ, sᵢ*, *tᵢ*) and the reference orientation (u, w, *v)* may be normalized vectors. Other comparisons could comprise computing an angle between the two vectors. The comparison may also comprise comparing a quantity such as inner product or angle with a threshold.

The opacity level may be a value that defines how opaque a piece of a pathway is rendered for display. The opacity level may be defined in a range, for example from zero to one, wherein zero corresponds to fully transparent and one corresponds to fully opaque. However, this is just an example. "Opaque" may mean that any object behind the pathway is not shown in a rendering of the pathways. "Transparent" may mean that an object behind the pathway is visible. Fully transparent may mean that the pathway is not visible at all in the rendering. For example, a fully transparent object does not need to be rendered at all because it is invisible. The terms opaque, transparent, and rendering are known to the person skilled in the art of computer graphics.

The orientation comparator may be arranged for computing a degree of similarity between the associated orientation and the reference orientation. For example, the degree of similarity may be represented by a numerical value indicating how similar or how different the associated orientation is compared to the reference orientation. This may be computed in one of many different ways. For example, the orientations may be represented by vectors, for example unit vectors. The reference orientation may be represented by a vector and the associated orientation may be represented by a vector. Different kinds of computations may be performed on these vectors to obtain a degree of similarity. For example, the inner product of the vectors may be computed. To improve the symmetry of the computation, the absolute value or the square of the inner product may be computed and used as the degree of similarity.

The opacity may be based on the degree of similarity. For example, the degree of similarity itself may be used as an opacity value. Also, the opacity associating unit 2 may be arranged for using a monotonically increasing or monotonically decreasing mapping to map the degree of similarity to the opacity level. This way, pathways pointing in one direction (defined by the reference orientation) may be associated with higher opacity, making the pathways orthogonal to that direction more transparent. Alternatively, the pathways pointing in the direction of the reference orientation may be associated with higher transparency, making the pathways orthogonal to the reference orientation more opaque. This way, at least two complementing views may be generated, based on the same reference orientation, to show different aspects of the dataset. The degree of similarity and the monotonic mapping make it possible to define intermediate opacity levels for somewhat similar orientations.

It is also possible that the opacity associating unit 2 uses a plurality of reference orientations. For example, a mapping may be used that maps an associated orientation, a first reference orientation, and a second reference orientation to an opacity level. For example, the opacity may be based on inner products of the associated orientation with each of a plurality of reference orientations.

The opacity associating unit may be arranged for associating an opacity level corresponding to a substantial transparency with at least part of a pathway having an orientation substantially parallel to the reference orientation. The opacity may increase for parts of pathways having an orientation increasingly different from the reference orientation. In another operating mode, the opacity associating unit may be arranged for associating an opacity level corresponding to a substantial transparency with at least part of a pathway having an orientation substantially orthogonal to the reference orientation. The pathways parallel to the reference orientation may then be made opaque.

The system may comprise a user interface element 4 arranged for enabling a user to select the reference orientation. For example, a visual representation of a rotatable object may be shown on a display, and the user interface element may enable the user to rotate the sphere by means of for example mouse drag or touch operations, and the reference orientation may be controlled by an orientation of the rotatable object. Further user interface elements may be provided to control other parameters of the system. For example, the system may comprise a user interface element (not shown) for enabling a user to select the mapping from a plurality of predetermined mappings and/or configure a parameter of the mapping. The user interface may be arranged for updating the display according to the new parameters (such as an updated reference orientation) in real-time.

The system may comprise a graphical subsystem 6 arranged for displaying the at least part of the pathway of the plurality of pathways as seen according to a viewing orientation on a display, using the associated opacity level. Graphical subsystems arranged for displaying three-dimensional datasets are known in the art per se. For example, surface rendering or volume rendering techniques such as ray casting may be employed by the graphical subsystem 6. To this end, the representation of the plurality of pathways may be converted into a suitable format, such as a three-dimensional surface model comprising surface elements such as triangles or a volume dataset comprising voxels. The opacity levels may be associated with the relevant surface elements or voxels. For example, the opacity level may be supplied as an alpha value in a red, green, blue, alpha (R, G, B, A) color system. The (R, G, B, A) color system is known in the art per se.

The graphical subsystem 6 may be arranged for displaying the plurality of pathways represented by the dataset 9 in combination with other image information relevant to the plurality of pathways. For example, an image representing anatomical information may be provided to the graphical subsystem 6. The anatomical image and the dataset 9 representing the plurality of pathways may be blended or rendered as overlays, using the associated opacity values for the plurality of pathways. Opacity values may be associated with the anatomical image dataset as well.

The graphical subsystem sets a viewing orientation or viewing direction to determine from which side the plurality of pathways are viewed. Also, a viewpoint may be set to determine a point of view from which the plurality of pathways is viewed. The system may be arranged for using the viewing orientation as the reference orientation. However, this is not a limitation. Setting the viewing orientation as the reference orientation makes it possible to influence the opacity of pathways by rotating the view. For example, parts of pathways that are parallel to the viewing direction may not provide much information to the user and may hide information about other pathways due to overlap. Consequently, these pathways parallel to the viewing direction may be made transparent, to reveal the underlying pathways.

Fig. 4 shows an example of using the viewing orientation as the reference orientation. In Fig. 4, the viewing direction is dorsoventral, as in Fig. 3. The figure shows the same dataset as shown in Fig. 3, but the opacity associating unit has been applied to associate a relatively low opacity value to the pathways that are (almost) parallel to the viewing direction. In this case, the pathways parallel to the viewing direction have been made transparent. The pathways 401 that are (almost) parallel to the projection plane of the graphical subsystem have been associated with a relatively high opacity value, and are rendered opaque. Fig. 8 shows a similar result for the lateral viewing direction.

Alternatively, the opacity of pathways may be set independently from the viewing direction. This way, a rotation of the view does not alter the opacity of the pathways shown.

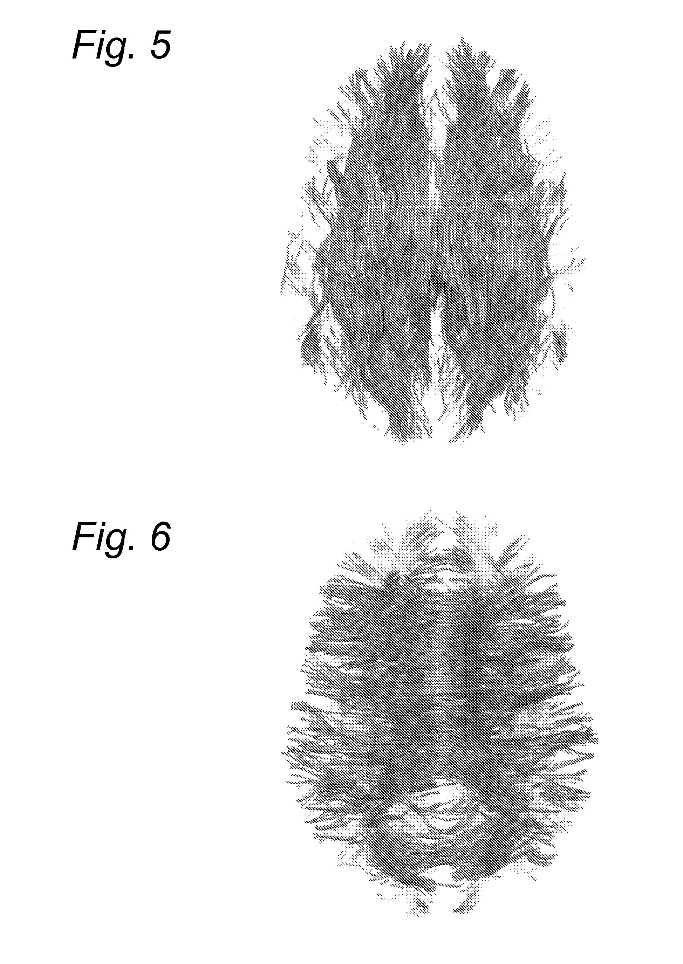

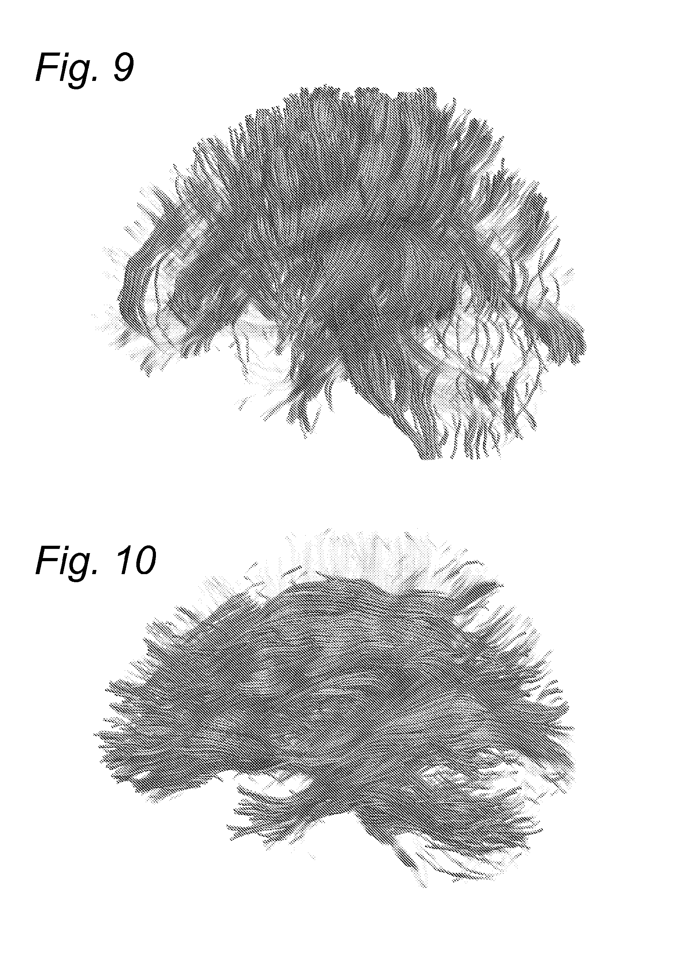

Fig. 5 shows a dorsoventral view of the dataset of Fig. 3, wherein a anteroposterior reference orientation has been employed. Moreover, higher opacity values have been associated with pathway segments having an orientation that is more similar to the reference orientation. Fig. 6 shows a similar view, with a lateral reference orientation. Fig. 9 shows a lateral view of the dataset with a dorsoventral reference orientation, wherein higher opacity values have been associated with pathway segments having an orientation that is more similar to the reference direction. Fig. 10 shows a similar view, with an anteroposterior reference orientation.

The system may comprise a reference orientation unit 5 arranged for setting the reference orientation based on a predetermined orientation with respect to an object represented by the dataset. For example, the dataset may represent a predetermined object type with predetermined shape characteristics. An example of a predetermined object is an organ. For example, a human brain. Another example of an object may be a lung. Another example is a building. For example, the dataset may comprise a representation of a shape of an object and a representation of a plurality of pathways within the object. The predetermined orientation may be defined, for example, with respect to the shape of the object. This way, the opacity may be controlled in a reproducible way for similar objects.

The system may comprise a reference orientation unit 5 for setting the reference orientation used by the orientation comparator in respect of a particular part of a pathway in dependence on a position of the part of the pathway in the three-dimensional space. For example, a three-dimensional function is defined as

For example, the orientation may be represented by a vector (rᵢ, *sᵢ, tᵢ),* wherein i is an index that denotes the part of the pathway with which the orientation (rᵢ, *sᵢ, tᵢ)* is associated. This part of the pathway may have a position *(xᵢ, yᵢ, zᵢ)* in three-dimensional space. Accordingly, the reference orientation may be made dependent on the position *(xᵢ, yᵢ, zᵢ*). In such a case, the previously introduced reference orientation vector (u, w, v) becomes (*uᵢ, wᵢ, vᵢ*). The comparison of a pathway orientation with a reference orientation may comprise, for example, computing an inner product with this position-dependent reference orientation vector, as follows: ((*rᵢ, sᵢ, tᵢ), (uᵢ,* wᵢ, *vᵢ*)). The location-dependent reference vector may have many applications. For example, it is possible to reveal all pathways that 'follow' a particular pathway by using the local orientations along that particular pathway as reference orientations for positions around that particular pathway.

The reference orientation may also be defined in terms of a curvilinear coordinate system. For example, a cylindrical or spherical coordinate system may be used. However, other curvilinear coordinate systems may also be used. The reference orientation may be fixed with respect to the curvilinear coordinate system. This results in a location-dependent reference orientation when the reference orientation is converted into a Cartesian coordinate system. For example, using a spherical coordinate system with coordinates (r, ϕ, θ), the reference orientation (1,0,0) can be used to make all pathways arranged in a star shape either transparent or opaque.

The opacity associating unit 2 may be arranged for computing an opacity level based on the orientation associated with a part of a pathway. The opacity associating unit 2 may be further arranged for associating the computed opacity level with the same part of the same pathway. In that case, the associated orientation and the associated opacity level relate to the same part of the same pathway. However, this is not a limitation. It is also possible to associate the computed opacity level with another part of the same pathway, or even with at least part of another pathway. For example, a region of interest may be defined. The region of interest may be defined using a user interface element. Alternatively, the region of interest may be defined automatically, based on an object represented by the dataset. The opacity associating unit 2 may be arranged for computing an opacity level based on a part of a pathway within the region of interest. The opacity associating unit 2 may be further arranged for associating the computed opacity level with the entire pathway. All the pathways intersecting the region of interest may be processed this way. The remaining pathways (that do not intersect the region of interest) may be associated with a predetermined opacity level, for example fully transparent. This allows to selectively visualize pathways based on their orientation within a region of interest.

For example, the orientation associating unit may be arranged for determining an overall orientation of a pathway, representing the approximate orientation of at least a large portion of the whole pathway, according to predetermined criteria. The orientation associating unit may be arranged for associating this overall orientation with the whole pathway. The opacity associating unit may be arranged for associating an opacity level with the whole pathway based on the associated orientation. For example, when the associated orientation corresponds to a predetermined reference orientation, the pathway may be made transparent by associating a low opacity value.

For example, the orientation of the pathways within the region of interest may be compared to a reference orientation, to show all pathways that are oriented in a particular direction within the region of interest. Alternatively, all pathways oriented orthogonally to the reference direction within the region of interest may be shown. This way, it can be shown which pathways would be affected by a cut in a given direction, for example, by setting the reference orientation to the direction of the cut.

The system may be implemented, for example, on a workstation having a display unit and a keyboard, mouse, and/or touch screen. The system may also be implemented in a distributed computing environment, for example as a web application.

Fig. 2 shows a flowchart illustrating aspects of a method of processing a dataset representing a plurality of pathways in a three-dimensional space. Before starting the method, the dataset representing a plurality of pathways in a three-dimensional space is prepared, as described above. In step 201, an orientation is associated with at least part of at least one pathway of the plurality of pathways. This step 201 results in an associated orientation. Step 201 may be repeated for different parts of the pathway and may be repeated for other pathways, until the orientations of the pathways have been determined in sufficient detail. This way, a plurality of associated orientations may be obtained. In step 202, an opacity level is associated with at least part of the at least one pathway based on the associated orientation. For example, the orientation and the opacity are associated with the same part of the same pathway. Step 202 results in an associated opacity level. Similar to step 201, step 202 may be repeated for different parts and different pathways, to obtain a plurality of associated opacity levels. For example, step 202 is performed for each associated orientation that was produced in step 201.

In step 203, the dataset is visualized on a display using the associated opacity levels for the parts of the pathways that have an associated opacity level. In step 204, it is determined whether the opacity level association is to be based on a reference orientation, and if so, whether the reference orientation is changed. The reference direction can be changed, for example, in response to a user input. If it is determined that the reference orientation is changed, the new reference orientation is set in step 206 and the associated opacity levels are re-computed in step 202.

In step 205, it is determined whether the viewing direction is changed. The viewing direction determines how the dataset is visualized in step 203. The viewing direction may be changed, for example, by enabling a user to rotate the visualization of the plurality of pathways, for example by means of a mouse drag operation. If it is determined that the viewing direction is changed, the viewing direction is updated in step 207, and in step 208 it is determined whether the reference orientation follows the viewing direction. If it is determined in step 208 that the reference orientation does not follow the viewing orientation, the plurality of pathways is displayed in step 203 using the same associated opacity levels as before. If, however, in step 208 it is determined that the reference orientation does follow the viewing direction, then the reference orientation is updated in step 209 and the associated opacity values are updated in step 202 in accordance with the updated reference orientation, and the dataset is visualized in step 203 with the updated associated opacity levels.

If in step 205 it is determined that the viewing direction does not change, the method is terminated in step 210.

The method may be modified based on this description. The method may also be implemented using a computer program.

Orientation dependent rendering of diffusion tractography streamlines may be performed. A spatially dependent transparency rendering of a plurality of pathways (for example, as reconstructed with diffusion MRI tractography) may be computed as a function of the orientation (either local or global) of these trajectories themselves. Moreover, the function may be dependent on a predefined reference orientation.

In a more specific example, the predefined reference orientation is an axis that is fixed with respect to the local coordinate system of the virtual camera object, such as the line defined by the camera position and the direction of viewing. In case of orthogonal rendering, a single reference orientation may be used for all pathways. In case of perspective rendering, the reference orientation used for a part of a pathway can be defined by the line intersecting the camera object and the part of the pathway.

In another example, the reference orientation can be any 3D axis fixed to the coordinate system of the trajectories, but not fixed to the local coordinate system of the virtual camera. The system may be configured such that the predefined orientation may be modified interactively (in real-time) during viewing operations.

The function for the transparency mapping can be any mathematical formula that takes, for example, the following arguments as input: (i) the orientation (either local or global) of the trajectories and (ii) the predefined orientation. The output range of the function may be within the range from zero to one, for example.

Some or all of the components described herein may be implemented on a desktop computer. For shorter response times, a fast graphics card may be used to perform at least some of the computationally intensive operations.

The architectural organization of the trajectories that are obtained with diffusion MRI tractography is typically very complex. Many pathways overlap each other making the visualization cluttered and obscure. As a result, it becomes impossible to distinguish between differently organized subsets of pathways. The techniques described herein may be used to provide more insight in these pathways.

It will be understood that the concepts of transparency level and opacity level are interchangeable. An opacity level defines a transparency level, and a transparency level defines an opacity level.

Some or all aspects of the invention may be suitable for being implemented in form of software, in particular a computer program product. Such computer program product may comprise a storage media on which the software is stored. Such a storage media may comprise, for example, an optical disc, magnetic disk, or flash memory. Also, the computer program may be represented by a signal, such as an optic signal or an electro-magnetic signal, carried by a transmission medium such as an optic fiber cable or the air. The computer program may partly or entirely have the form of source code, object code, or pseudo code, suitable for being executed by a computer system. For example, the code may be directly executable by one or more processors. Alternatively, the code may be interpreted by an interpreter that is executed by one or more processors. It will be understood that portions of the systems described herein may be implemented in form of software. Moreover, the method steps described herein may be implemented partially or completely in software. The software may be organized by means of subroutines. The subroutines may be combined to form a standalone executable program. Alternatively, the subroutines may be organized as a dynamically linkable library. A main program executable file may be provided that uses the subroutines from the dynamically linkable library. Each of the processing steps and/or system components described herein may be represented by executable code, be it in a dynamically linked library or in an executable file. Some, or all, of the functionality may be implemented as part of an operating system, some functionality may be implemented in a dynamically linked library, and some functionality may be implemented as an application program file.

The examples and embodiments described herein serve to illustrate rather than limit the invention. The person skilled in the art will be able to design alternative embodiments without departing from the scope of the claims. Reference signs placed in parentheses in the claims shall not be interpreted to limit the scope of the claims. Items described as separate entities in the claims or the description may be implemented as a single hardware or software item combining the features of the items described.

## Claims

1. A system for processing a dataset representing a plurality of pathways in a three-dimensional space, comprising
an orientation associating unit for associating an orientation with at least part of at least one pathway of the plurality of pathways, to obtain an associated orientation; and
an opacity associating unit for associating an opacity level with at least part of the at least one pathway based on the associated orientation, to obtain an associated opacity level.

2. The system according to claim 1, wherein the opacity associating unit comprises an orientation comparator for comparing the associated orientation with a reference orientation.

3. The system according to claim 2, wherein the orientation comparator is arranged for computing a degree of similarity between the associated orientation and the reference orientation.

4. The system according to claim 3, wherein the opacity associating unit is arranged for using a monotonically increasing or monotonically decreasing mapping to map the degree of similarity to the opacity level.

5. The system according to claim 4, wherein the opacity associating unit is arranged for associating an opacity level corresponding to a substantial transparency with at least part of a pathway having an orientation substantially parallel or substantially orthogonal to the reference orientation.

6. The system according to any one of claims 2 to 5, comprising a user interface element for enabling a user to select the reference orientation.

7. The system according to any one of claims 2 to 5, wherein the orientation comparator is arranged for using a viewing orientation as the reference orientation.

8. The system according to any one of claims 2 to 6, comprising a reference orientation unit for setting the reference orientation based on a predetermined orientation with respect to an object represented by the dataset.

9. The system according to any one of claims 2 to 8, comprising a reference orientation unit for setting the reference orientation used by the orientation comparator in respect of a particular part of a pathway in dependence on a position of the part of the pathway in the three-dimensional space.

10. The system according to any preceding claim, wherein the associated orientation or the reference orientation is defined in terms of a curvilinear coordinate system.

11. The system according to any preceding claim, further comprising a pathway generator for generating the dataset comprising the plurality of pathways based on a medical image dataset.

12. The system according to any preceding claim, further comprising a graphical subsystem for displaying the at least part of the pathway of the plurality of pathways as seen according to a viewing orientation on a display, using the associated opacity level.

13. The system according to any preceding claim, wherein the dataset comprises a diffusion magnetic resonance tractography dataset.

14. A method of processing a dataset representing a plurality of pathways in a three-dimensional space, comprising
associating an orientation with at least part of at least one pathway of the plurality of pathways, to obtain an associated orientation; and
associating an opacity level with at least part of the at least one pathway based on the associated orientation, to obtain an associated opacity level.

15. A computer program product comprising instructions for causing a processor system to perform the method according to claim 14.
